(19) Europäisches Patentamt
European Patent Office
Office européen des brevets

(11) EP 3 709 509 A1

(12) EUROPEAN PATENT APPLICATION

(43) Date of publication:
16.09.2020 Bulletin 2020/38

(51) Int Cl.:
*H03D 7/16* (2006.01)

(21) Application number: 20151316.5

(22) Date of filing: 10.01.2020

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 14.03.2019 US 201916353443

(71) Applicant: Honeywell International Inc.
Morris Plains, NJ 07950 (US)

(72) Inventors:
• STRANDJORD, Lee K.
Morris Plains, NJ New Jersey 07950 (US)
• TARLETON, Norman Gerard
Morris Plains, NJ New Jersey 07950 (US)
• WU, Jianfeng
Morris Plains, NJ New Jersey 07950 (US)
• SMICIKLAS, Marc
Morris Plains, NJ New Jersey 07950 (US)
• SANDERS, Glen A.
Morris Plains, NJ New Jersey 07950 (US)

(74) Representative: Haseltine Lake Kempner LLP
Lincoln House, 5th Floor
300 High Holborn
London WC1V 7JH (GB)

(54) SYSTEM AND METHOD FOR NARROW BAND NEGATIVE FEEDBACK CONTROL

(57) A system, feedback controller and method are disclosed. For example, the feedback controller includes a phase-sensitive quadrature controller configured to generate a first control signal associated with a controlled signal, a phase-sensitive in-phase controller configured to generate a second control signal associated with the controlled signal, a summer configured to add the first control signal and the second control signal, and a subtractor configured to subtract the summed first and second control signals from an uncontrolled signal.

FIG. 3

## Description

## BACKGROUND

Negative feedback is utilized in many systems to reduce unwanted variability in system states. For example, negative feedback can be utilized to stabilize the temperature of an object or reduce fluctuations in the operating frequency of a device (e.g., smooth the optical frequency of a laser). In certain cases, the unwanted variability can occur within a narrow frequency band of a system state, but some degree of variability is needed within different frequency bands or other states. For one example, in the operation of certain optical sensors, the light signals utilized for sensing are phase modulated, but measurement errors can occur if the intensities of the light signals are also amplitude modulated. For this case, wideband negative feedback is commonly employed, but can require high-speed components that can lead to higher electrical power requirements and higher product cost. Narrowband negative feedback control can be utilized in such systems to eliminate the intensity modulation of the light signals while preserving the phase modulation while not requiring high-speed components, thus leading to lower electrical power requirements and lower product cost. Similarly, for example, narrowband feedback control of a system state can be utilized if a digital or analog signal is operating at a fundamental frequency, and a second signal operating at a higher harmonic frequency of that signal is deemed interference and thus harmful to the performance of the system involved. In this case, narrowband negative feedback control can be utilized to remove those signals at the harmonic frequencies close to the fundamental frequency, but without impacting the fundamental frequency itself.

Notably, many lower cost systems have extremely limited frequency bandwidths. For example, these systems can include electronic components, actuators, modulators and the like, which are inexpensive and small. Typically, these systems have extremely limited frequency bandwidths. Also, the loop gain of these systems at the noise frequency can be severely limited if the frequency of the desired signal is close enough to the frequency of the noise signal, because the loop gain needs to be small at the frequency of the desired signal to minimize the impact of the noise. Notably, an existing technique for reducing the noise level is to increase the bandwidth of the stabilization loop. However, this technique is relatively expensive and increases the size, weight and power (SWaP) of the circuitry and components utilized.

For the reasons stated above and for other reasons stated below which will become apparent to those skilled in the art upon reading and understanding the specification, there is a need in the art for a technique that can be utilized to measure and control the noise in a negative feedback control system at selected frequencies in a manner that does not significantly increase the cost and SWaP of the circuitry and components utilized.

## SUMMARY

Embodiments disclosed herein present techniques for controlling the noise in a high gain, narrowband, negative feedback control system in a manner that minimizes the cost and SWaP of the circuitry and components utilized.

## DRAWINGS

Embodiments of the present disclosure can be more easily understood and further advantages and uses thereof more readily apparent, when considered in view of the description of the preferred embodiments and the following figures in which:

FIG. 1 is a diagram depicting a Bode plot representing an exemplary wideband negative feedback system that can be utilized to implement one example embodiment of the present invention.

FIG. 2 is a schematic block diagram of a system that can be utilized to implement one example embodiment of the present invention.

FIG. 3 is schematic block diagram of a system that can be utilized to implement one embodiment of the exemplary system depicted in FIG. 2.

FIG. 4 is a flow diagram illustrating a method that can be utilized to implement one example embodiment of the present invention.

FIG. 5 depicts an example Bode plot of a stable feedback control loop utilizing two feedback loops, which can be implemented in accordance with one example embodiment of the present invention.

In accordance with common practice, the various described features are not drawn to scale but are drawn to emphasize features relevant to the present disclosure. Reference characters denote like elements throughout the figures and text.

## DETAILED DESCRIPTION

In the following detailed description, reference is made to the accompanying drawings that form a part hereof, and in which is shown by way of specific illustrative embodiments in which the embodiments may be practiced. These embodiments are described in sufficient detail to enable those skilled in the art to practice the embodiments, and it is to be understood that other embodiments may be utilized and that logical, mechanical and electrical changes may be made without departing from the scope of the present disclosure. The following detailed description is, therefore, not to be taken in a limiting sense.

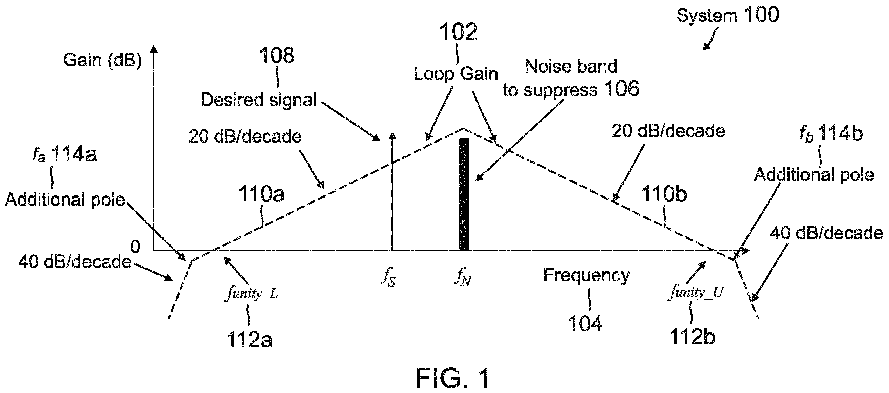

FIG. 1 is a diagram 100 depicting a Bode plot representing an exemplary wideband negative feedback system that can be utilized to reduce unwanted variability within a narrow frequency band, in accordance with one example embodiment of the present invention. Notably, as indicated in FIG. 1, the diagram 100 depicts the system's loop gain 102 versus frequency 104. In the system thus represented, a signal generator generates a real signal (e.g., a desired signal plus some noise). A portion of the generated signal is tapped from the system's output and coupled to an input of a controller. The controller outputs a control signal, which is subtracted from the generated signal.

As indicated by the exemplary Bode plot depicted in FIG. 1, the system's feedback loop and its key frequency values are shown along with the frequency band of the unwanted noise (e.g., noise band to suppress) 106 centered at the frequency, $f_N$, and the frequency of the desired signal 108 indicated as the frequency, $f_s$. The feedback loop gain design of this system is represented by the dashed lines 110a, 110b. An integrator is utilized to provide gain that rolls off with frequency at a rate of 20 dB/decade, as indicated by the dashed line 110b. A second order, high-pass filter with a corner frequency of approximately the noise frequency, $f_N$, is combined with the integrator to produce a 20 dB/decade roll off (110a) for the frequencies lower than the noise frequency, $f_N$. Notably, the rule-of-thumb for attaining a suitable degree of stability in a negative feedback system is that the system will be stable as long as the loop gain is adapted to roll off at 20 dB/decade when the loop gain passes through the unity gain crossover frequency. For example, as depicted in FIG. 1, two unity gain crossover frequencies, $f_{unity\_L}$ 112a and $f_{unity\_U}$ 112b, are shown.

The amount of noise attenuation provided by the negative feedback in the system 100 depicted in FIG. 1 is approximately proportional to the feedback loop gain at the noise frequency, $f_N$. As such, if substantially high levels of noise attenuation are required, the feedback loop gain at the noise frequency, $f_N$, must be relatively high. Nevertheless, the maximum amount of loop gain at the noise frequency is limited by certain elements (e.g., circuits, modulators, actuators, signal propagation delays, etc.) in the control loop that produce imperfections that introduce additional, undesirable frequency responses in the feedback loop. For example, the frequencies indicated as $f_a$ 114a and $f_b$ 114b represent the corner frequencies introduced by the above-described limitations or imperfections in the control loop shown. In this case, the loop gain above the corner frequency, $f_b$ 114b and below the corner frequency, $f_a$ 114a rolls off at 40 dB/decade. If the overall loop gain at all frequencies is increased to a high enough level, the unity gain crossover frequencies $f_{unity\_L}$ 112a and $f_{unity\_U}$ 112b will occur when the gain roll-off is much greater than 20 dB/decade and, consequently, the control loop is likely to be unstable.

Therefore, the unity gain crossover frequency $f_{unity\_U}$ 112b has to be less than $f_b$ 114b, and the unity gain crossover frequency $f_{unity\_L}$ 112a has to be greater than $f_a$ 114a. As such, this diagram indicates that the maximum loop gain possible at the noise frequency, $f_N$ is limited by the corner frequencies $f_a$ 114a and $f_b$ 114b.

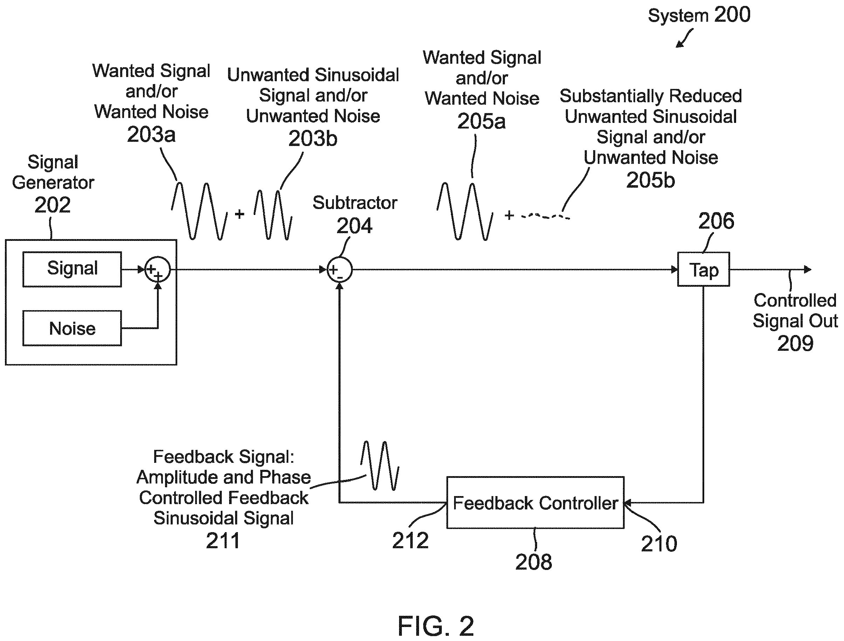

FIG. 2 is a schematic block diagram of a system 200, which can be utilized to implement one example embodiment of the present invention. For example, the system 200 can be utilized to implement a stable, negative feedback control loop having a high loop gain within a narrow frequency band. Referring to FIG. 2, the system 200 includes a signal generator 202 coupled to a positive terminal of a subtractor 204. For this embodiment, the signal generator 202 outputs a signal including a nominal amount of noise. More precisely, for example, the signal generator 202 outputs a wanted (e.g., desired) signal and/or wanted noise 203a plus an unwanted (e.g., undesired) sinusoidal signal and unwanted noise 203b. The output terminal of the subtractor 204 is coupled to an input terminal of a tap 206. One (e.g., "tapped") output of the tap 206 is coupled to an input terminal 210 of a feedback controller 208, and a second output of the tap 206 is coupled to the output terminal 209 of the system 200. An output terminal 212 of the feedback controller 208 is coupled to the negative input terminal of the subtractor 204.

In operation of the exemplary system 200, the signal generator 202 generates and outputs a wanted signal, and due to imperfections in the signal generation process, the signal generator 202 also generates and outputs an unwanted signal. The wanted signal can be a sinusoidal signal or noise, or both a sinusoidal signal and noise, as depicted at 203a. The unwanted signal can be a sinusoidal signal and/or noise in a narrow frequency band, as depicted at 203b. The feedback controller 208 generates a feedback signal, as depicted at 211, which is an amplitude- and phase-controlled sinusoidal signal having an amplitude and phase that is nearly equal to that of the unwanted signal and/or noise in the narrow frequency band. The subtractor 204 subtracts the feedback signal 211 from the generated signal 203a and 203b. Notably, for this embodiment, the feedback signal 211 has nearly the same amplitude and phase as the unwanted signal. Consequently, the signal at the output terminal of the subtractor 204 includes the wanted signal and/or wanted noise 205a with little or no change, and a substantially amplitude-reduced unwanted sinusoidal signal and/or noise 205b. The tap 206 couples one portion of the output signal from the subtractor 204 to the feedback controller 208, and also couples a second portion of the output signal from the subtractor 204 to the output terminal 209 of the system 200. The feedback controller 208 adjusts the amplitude and phase of the feedback signal 211 to minimize the amplitude of the unwanted signal at the input terminal 210 of the feedback controller 208, as described in detail below.

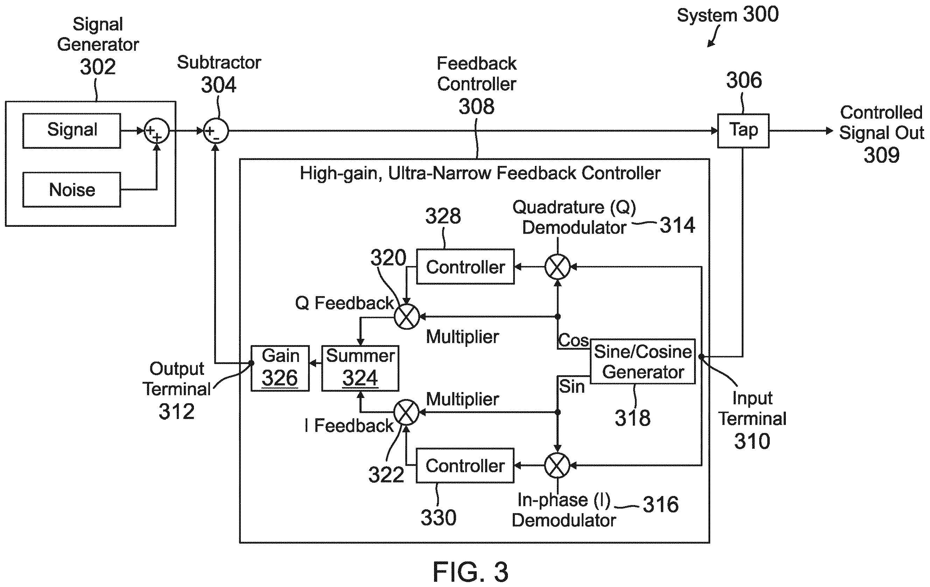

FIG. 3 is schematic block diagram of a system 300, which can be utilized to implement one embodiment of the exemplary system 200 depicted in FIG. 2. Specifically, the system 300 depicted in FIG. 3 includes a high-gain, ultra-narrow feedback controller 308, which can be utilized to implement one embodiment of the feedback controller 208 depicted in and described above with respect to FIG. 2. Referring to FIG. 3, for this example embodiment, the feedback controller 308 includes a quadrature (Q) demodulator 314 and an in-phase (I) demodulator 316. One output (Cos) of a sine/cosine signal generator 318 is coupled to an input of the quadrature (Q) demodulator 314 and a first input terminal of a first multiplier 320. A second output (Sin) of the sine/cosine signal generator 318 is coupled to an input of the in-phase (I) demodulator 316 and a first input terminal of a second multiplier 322. The output of the quadrature demodulator 314 is coupled to an input of a first controller 328, and the output of the first controller 328 is coupled to the second input of the first multiplier 320. The output of the first multiplier 320 is coupled to a first input terminal of a summer 324. The output of the in-phase demodulator 316 is coupled to an input of a second controller 330, and the output of the second controller 330 is coupled to a second input of the second multiplier 322. The output of the second multiplier 322 is coupled to a second input terminal of the summer 324. The output terminal of the summer 324 is coupled to an input of a gain stage 326, and the output terminal of the gain stage 326 is coupled to the output terminal 312 of the feedback controller 308.

In operation of the exemplary system 300, the signal transmitted from the output terminal of the subtractor 304 is tapped (306) and coupled to both the Q demodulator 314 and the I-phase demodulator 316. The demodulators 314, 316 are configured to demodulate the respective, incoming signals down to a frequency represented as $f_{democ}$, which frequencies are selected to be at the noise frequency, $f_N$ or substantially at the middle of the noise frequency band to be attenuated. The demodulated signals are then coupled to the respective controllers 328 and 330, which are configured to control the amplitudes of the sine wave and cosine wave generated at the noise frequency, $f_N$. Next, the amplitude-controlled sine wave signals and cosine wave signals are algebraically added by the summer 324. The algebraically summed signal at the output of the summer 324 is then coupled to the gain stage 326, which amplifies the incoming signal. The amplified signal is then coupled from the output terminal 312 of the feedback controller 308 to the negative input terminal of the subtractor 304.

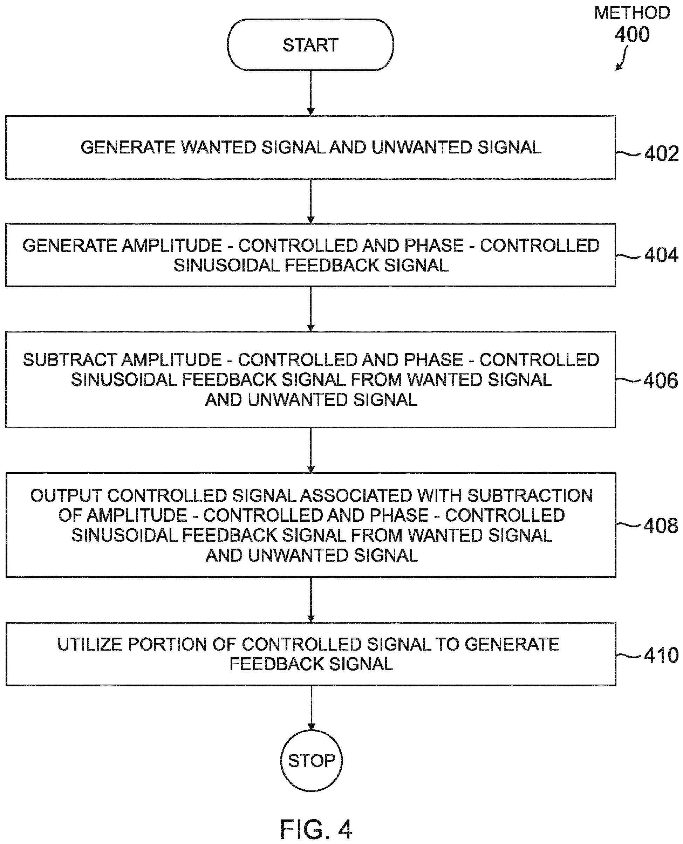

FIG. 4 is a flow diagram illustrating a method 400, which can be utilized to implement one example embodiment of the present invention. Referring to FIG. 4 and the example embodiments depicted in FIGS. 2 and 3, the exemplary method 400 begins with a signal generator generating a wanted signal and an unwanted signal (402). For example, in FIG. 2, the signal generator 202 generates a wanted signal that can be a sinusoidal signal or noise or both, as depicted at 203a. The signal generator 202 also generates an unwanted signal that can be sinusoidal and/or noise in a narrow frequency band, as depicted at 203b. Next, the method generates a feedback signal (404). For example, in FIG. 2, the feedback controller 208 generates a feedback signal that is an amplitude- and phase-controlled sinusoidal signal, as depicted at 211. The generated feedback signal has an amplitude and phase that are nearly (e.g., substantially) equal to the amplitude and phase of the unwanted signal and/or unwanted narrowband noise. The method then subtracts the feedback signal from the wanted and unwanted signals generated by the signal generator (406). For example, in FIG. 2, the subtractor 204 subtracts the feedback signal 211 from the generated signal 203a, 203b. Since the feedback signal 211 has substantially the same amplitude and phase as that of the unwanted signal 203b, the signal at the output of the subtractor 204 includes the wanted signal 205a with little or no amplitude change, and an unwanted signal 205b with a substantially reduced amplitude 205b. The method then couples the signal at the output of the subtractor to an input of the feedback controller (408). For example, the tap 206 "taps" a portion of the signal at the output terminal of the subtractor 204 and couples that portion to the input terminal of the feedback controller 208. In turn, the feedback controller 208 then utilizes that portion of the output signal to generate the feedback signal (410). The tap 206 also couples a second portion of that signal (e.g., controlled signal out) to the output terminal 209 of the system 200. The method is then terminated.

In summary, as depicted in FIGS. 2 through 4, and in accordance with an example embodiment of the present invention, a feedback controller includes a dual-phase demodulator to reduce noise by generating quadrature (Q) and in-phase (I) error signals. The error signals are integrated to generate control signals for controlling the amplitudes of quadrature and in-phase continuous (cosine/sine) wave signals. These continuous wave signals are summed together, and the summed signal is amplified and then subtracted from the controlled signal. Thus, in accordance with the above-described teachings of the present description, a stable feedback control loop is provided with a high level of loop gain within a narrow frequency band.

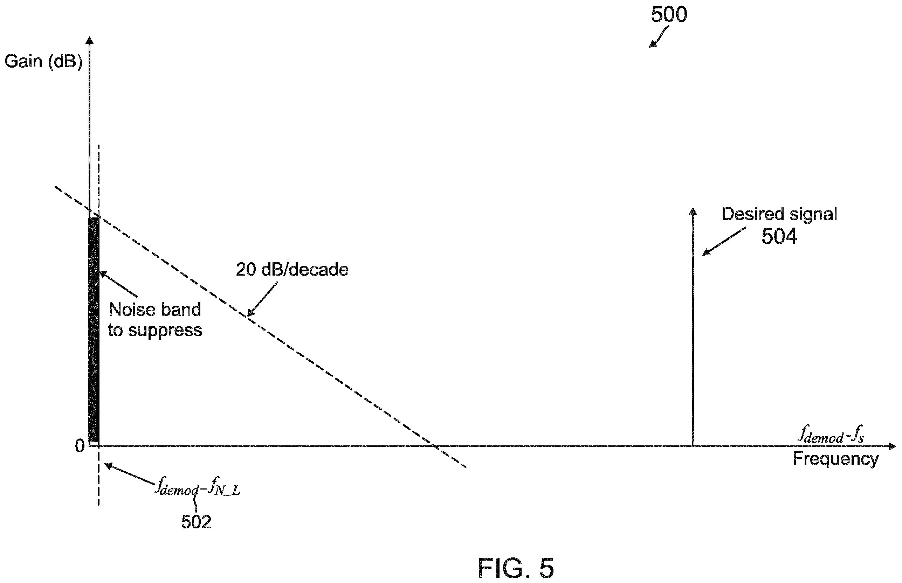

Notably, the exemplary approach described above utilizes two feedback loops, with one loop controlling the quadrature signal and the other loop controlling the in-phase signal. FIG. 5 depicts an example Bode plot 500 that illustrates this approach. Specifically, FIG. 5 depicts the in-phase or quadrature loop bandwidth measured at the output of the Q-phase or I-phase demodulator (e.g., 314 or 316 in FIG. 3) involved. As indicated at 502, the signal at the demodulated frequency $f_{democ}$ is frequency translated down to essentially zero frequency (e.g.,

$f_{democ}$ minus the lower frequency of the noise band, or $f_{N\_L}$. Therefore, the frequency band of the noise signal to be controlled is from approximately zero frequency to $\frac{1}{2}\Delta f$ , where $\Delta f$ is the entire width of the frequency band of the noise to be attenuated. Notably, although the desired signal 504 is presumably filtered out within the controller utilized, the effective frequency of the desired signal at the output of the demodulator is $f_{demod}$-$f_s$. To attenuate the noise signal at the desired level, the loop gain required at $\frac{1}{2}\Delta f$ can be represented as $G_{req}$. The loop gain in dB, as a function of frequency, can be approximated as $G_{loop}(f) = 20 Log\left(\dfrac{f_{unity}}{f}\right)$

If the unity gain crossover frequency $f_{unity}$ is no greater than 1/10th of the desired signal in the demodulated frequency space, then the gain of the feedback loop will be very small at the frequency of the desired signal. Also, a suitable filter can be provided at the output of the demodulator to further reduce the loop gain at the frequency of the desired signal, in order to reduce any further impact on the signal. As such, utilizing the criteria $f_{unity} = \dfrac{1}{10}\left(f_{demod} - f_s\right),$ then the loop gain, $G_{loop}(f) = 20 Log\left(\dfrac{\left(f_{demod} - f_s\right)}{10 f}\right),$ and the loop gain at the demodulated noise frequency band is $G_{loop}\left(\dfrac{1}{2}\Delta f\right) = 20 Log\left(\dfrac{\left(f_{demod} - f_s\right)}{5\Delta f}\right).$

For example, utilizing the narrowband negative feedback system and method described above, the center of the noise frequency band $f_N$ can be set to 80 kHz, the signal frequency $f_s$ set to 40 kHz, and the noise frequency band $\Delta f$ set to 10 Hz. Therefore, utilizing the above-described narrowband, negative feedback control system and method, the loop gain at the frequency band of the noise at the demodulator output is approximately 58 dB, and the loop gain is significantly less than unity at the frequency of the desired signal. Therefore, it is important to note that embodiments of the present invention can achieve high attenuation of the noise signal without significantly impacting the level of the desired signal. In contrast, if the narrowband negative feedback system and method described above is not utilized, and the wideband feedback system loop gain at the frequency of the noise signal is 58 dB, then the loop gain at the frequency of the desired signal will be at about 46 dB (the frequency of the desired signal is merely one octave away from the frequency of the noise signal), which will significantly impact the desired signal.

Note that the above-described example embodiments assume that first order feedback loops are being utilized. However, if higher attenuation is required at the frequency of the noise signal, then in a different embodiment, a second order feedback loop could be utilized. For example, the second order loop could utilize two integrators in series, but to maintain the stability of the loop, one of the integrators would have a zero in its frequency transfer function. The zero in the frequency transfer function would function to flatten the frequency response of the second integrator before the loop gain crosses unity, and thus ensure that the loop gain rolls off at -20 dB/decade through the unity gain crossover frequency. Also note that, in other embodiments, other types of controllers can be utilized in the above-described narrowband feedback control loops, such as, for example, a proportional, integral and derivative (PID) controller.

It should be understood that elements of the above described embodiments and illustrative figures may be used in various combinations with each other to produce still further embodiments which are explicitly intended as within the scope of the present disclosure.

**EXAMPLE EMBODIMENTS**

Example 1 includes a feedback controller, comprising: a phase-sensitive quadrature controller configured to generate a first control signal associated with a controlled signal; a phase-sensitive in-phase controller configured to generate a second control signal associated with the controlled signal; a summer configured to add the first control signal and the second control signal; and a subtractor configured to subtract the summed first and second control signals from an uncontrolled signal.

Example 2 includes the feedback controller of Example 1, wherein the feedback controller is a narrowband feedback controller.

Example 3 includes the feedback controller of any of Examples 1-2, wherein the first control signal is a quadrature-phase control signal, and the second control signal is an in-phase control signal.

Example 4 includes the feedback controller of any of Examples 1-3, wherein the first control signal is out of phase with the second control signal.

Example 5 includes the feedback controller of any of Examples 1-4, wherein the first control signal is an amplitude-controlled cosine wave signal, and the second control signal is an amplitude-controlled sine wave signal.

Example 6 includes the feedback controller of any of Examples 1-5, wherein the controlled signal is tapped and coupled to an input terminal of the feedback controller.

Example 7 includes the feedback controller of any of Examples 1-6, further comprising a sine/cosine generator coupled to a reference input of a quadrature demodulator and a reference input of an in-phase demodulator, and configured to generate a cosine wave signal at the output of the quadrature demodulator and a sine wave signal at the output of the in-phase demodulator.

Example 8 includes the feedback controller of any of Examples 1-7, wherein the feedback controller comprises a high gain, narrowband feedback controller.

Example 9 includes the feedback controller of any of Examples 1-8, wherein the feedback controller comprises a negative feedback controller.

Example 10 includes the feedback controller of any of Examples 1-9, wherein the feedback controller includes a dual-phase demodulator.

Example 11 includes a method for feedback control, comprising: generating a wanted signal and an unwanted signal; generating an amplitude-controlled and phase-controlled sinusoidal feedback signal; subtracting the feedback signal from the wanted signal and the unwanted signal; outputting a controlled signal associated with the subtraction of the feedback signal from the wanted signal and the unwanted signal; and utilizing a portion of the controlled signal to generate the amplitude-controlled and phase-controlled sinusoidal feedback signal.

Example 12 includes the method of Example 11, wherein the outputting the controlled signal comprises a signal generator generating at least a real signal.

Example 13 includes the method of any of Examples 11-12, wherein the generating the amplitude-controlled and phase-controlled sinusoidal feedback signal comprises generating a cosine wave control signal.

Example 14 includes the method of any of Examples 11-13, wherein the generating the amplitude-controlled and phase-controlled sinusoidal feedback signal comprises generating a sine wave control signal.

Example 15 includes the method of any of Examples 11-14, further comprising tapping the controlled signal, and coupling the tapped controlled signal to an input terminal of a feedback controller.

Example 16 includes the method of any of Examples 11-15, wherein the utilizing the portion of the controlled signal to generate the amplitude-controlled and phase-controlled sinusoidal feedback signal comprises coupling the portion of the controlled signal to an input of a high gain, narrowband, negative feedback controller, and the high gain, narrowband, negative feedback controller generating the amplitude-controlled and phase-controlled sinusoidal feedback signal in response to the portion of the controlled signal.

Example 17 includes a system, comprising: a signal generator configured to generate a controlled signal including an unwanted signal; a feedback controller, wherein an output of the signal generator is coupled to an input of the feedback controller, wherein the feedback controller is configured to produce an output that is an amplitude- and phase-controlled sinusoidal signal having an amplitude and phase that is nearly equal to that of the unwanted signal in a narrow frequency band; and a subtractor, wherein the output of the signal generator is coupled to a first input of the subtractor, and the output of the feedback controller is coupled to a second input of the subtractor.

Example 18 includes the system of Example 17, wherein the subtractor is configured to subtract a signal at the second input from a signal at the first input.

Example 19 includes the system of any of the examples 17-18, wherein the feedback controller includes a phase sensitive quadrature demodulator configured to generate a first control signal associated with the controlled signal, and a phase sensitive in-phase demodulator configured to generate a second control signal associated with the controlled signal.

Example 20 includes the system of any of the examples 17-19, wherein the feedback controller comprises a high gain, narrowband, negative feedback controller.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the presented embodiments. Therefore, it is manifestly intended that embodiments be limited only by the claims and the equivalents thereof.

Claims

1. A feedback controller, comprising:

a phase-sensitive quadrature controller configured to generate a first control signal associated with a controlled signal;
a phase-sensitive in-phase controller configured to generate a second control signal associated with the controlled signal;
a summer configured to add the first control signal and the second control signal; and
a subtractor configured to subtract the summed first and second control signals from an uncontrolled signal.

2. The feedback controller of claim 1, wherein the feedback controller is a narrowband feedback controller.

3. The feedback controller of claim 1, wherein the first control signal is a quadrature-phase control signal, and the second control signal is an in-phase control signal.

4. The feedback controller of claim 1, wherein the first control signal is out of phase with the second control signal.

5. The feedback controller of claim 1, wherein the first control signal is an amplitude-controlled cosine wave signal, and the second control signal is an amplitude-controlled sine wave signal.

6. The feedback controller of claim 1, wherein the controlled signal is tapped and coupled to an input terminal of the feedback controller.

7. The feedback controller of claim 1, further comprising a sine/cosine generator coupled to a reference input of a quadrature demodulator and a reference input of an in-phase demodulator, and configured to generate a cosine wave signal at the output of the quadrature demodulator and a sine wave signal at the output of the in-phase demodulator.

8. The feedback controller of claim 1, wherein the feedback controller comprises a high gain, narrowband feedback controller.

9. The feedback controller of claim 1, wherein the feedback controller comprises a negative feedback controller.

10. The feedback controller of claim 1, wherein the feedback controller includes a dual-phase demodulator.

FIG. 1

FIG. 2

FIG. 3

EP 3 709 509 A1

METHOD
**400**

START

GENERATE WANTED SIGNAL AND UNWANTED SIGNAL ~402

GENERATE AMPLITUDE - CONTROLLED AND PHASE - CONTROLLED SINUSOIDAL FEEDBACK SIGNAL ~404

SUBTRACT AMPLITUDE - CONTROLLED AND PHASE - CONTROLLED SINUSOIDAL FEEDBACK SIGNAL FROM WANTED SIGNAL AND UNWANTED SIGNAL ~406

OUTPUT CONTROLLED SIGNAL ASSOCIATED WITH SUBTRACTION OF AMPLITUDE - CONTROLLED AND PHASE - CONTROLLED SINUSOIDAL FEEDBACK SIGNAL FROM WANTED SIGNAL AND UNWANTED SIGNAL ~408

UTILIZE PORTION OF CONTROLLED SIGNAL TO GENERATE FEEDBACK SIGNAL ~410

STOP

FIG. 4

FIG. 5

Europäisches
Patentamt

European
Patent Office

Office européen
des brevets

## EUROPEAN SEARCH REPORT

Application Number

EP 20 15 1316

## DOCUMENTS CONSIDERED TO BE RELEVANT

| Category | Citation of document with indication, where appropriate, of relevant passages | Relevant to claim | CLASSIFICATION OF THE APPLICATION  (IPC) |
|---|---|---|---|
| X | US 2013/057870 A1 (STRANDJORD LEE K [US] ET AL) 7 March 2013 (2013-03-07) * paragraph [0015] - paragraph [0034]; figures 1, 2 * | 1-10 | INV. H03D7/16 |
| X | EP 2 787 410 A2 (HONEYWELL INT INC [US]) 8 October 2014 (2014-10-08) * figure 1 * | 1 | |

TECHNICAL FIELDS
SEARCHED       (IPC)

H03D

The present search report has been drawn up for all claims

| Place of search | Date of completion of the search | Examiner |
|---|---|---|
| Munich | 20 July 2020 | Schnabel, Florian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 15 1316

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2020

| Patent document cited in search report | | Publication date | Patent family member(s) | | Publication date |
|---|---|---|---|---|---|
| US 2013057870 | A1 | 07-03-2013 | EP | 2236983 A2 | 06-10-2010 |
| | | | EP | 2541195 A1 | 02-01-2013 |
| | | | JP | 5480950 B2 | 23-04-2014 |
| | | | JP | 5538980 B2 | 02-07-2014 |
| | | | JP | 2010243493 A | 28-10-2010 |
| | | | JP | 2013019915 A | 31-01-2013 |
| | | | US | 2010253948 A1 | 07-10-2010 |
| | | | US | 2013057870 A1 | 07-03-2013 |
| EP 2787410 | A2 | 08-10-2014 | EP | 2787410 A2 | 08-10-2014 |
| | | | JP | 2014204432 A | 27-10-2014 |
| | | | US | 2014294117 A1 | 02-10-2014 |

EPO FORM P0459

For more details about this annex : see Official Journal of the European Patent Office, No. 12/82